# EUROPEAN PATENT APPLICATION

(11) **EP 4 459 800 A1**
(43) Date of publication of application: **06.11.2024**
(21) Application number: 24173801.2
(22) Date of filing: 02.05.2024
(51) Int. Cl.: H01R 9/11, H01R 13/00

(54) **ELECTRIC CONNECTION MEMBER AND ELECTRIC CONNECTION ASSEMBLY**

(30) Priority: 04.05.2023 CN 202310489188
(71) Applicant: Tyco Electronics (Suzhou) Ltd., Suzhou City, Jiangsu Province 215126 (CN); Tyco Electronics Technology (SIP) Ltd., Suzhou 215026 (CN); Tyco Electronics (Shanghai) Co., Ltd., Pilot Free Trade Zone Shanghai 200131 (CN)
(72) Inventor: Wang, Jinshun, Suzhou, 32 215123 (CN); Zhu, Fangyue, Shanghai, 200233 (CN); Xu, Ming, Shanghai, 200233 (CN); Qi, Jianwei, Suzhou, 32 215123 (CN)
(74) Representative: Grünecker Patent- und Rechtsanwälte PartG mbB

(57) **Abstract**

The present invention discloses an electric connection member and an electric connection assembly. The electric connection member comprises: an electric transmission body (30) which is in the shape of a hollow tube; a first connection end (31) which is connected to one end of the electric transmission body (30); and a second connection end (32) which is connected to the other end of the electric transmission body (30). The electric connection member (3) is an integral piece, and the first connection end (31) is adapted to be detachably electrically connected to a charging terminal (11) of a charging seat (1) or the second connection end (32) is adapted to be detachably electrically connected to a connection terminal of a connector (2). The inner cavity of the electric transmission body (30) is served as a cooling fluid flow channel, and a first fluid through-hole (3a) and a second fluid through-hole (3b) are respectively formed in the circumferential walls at both ends of the electric transmission body (30), to allow the cooling fluid to flow into the electric transmission body (30) through one of the first fluid through-hole (3a) and the second fluid through-hole (3b), and flow out of the electric transmission body (30) through the other of the first fluid through-hole (3a) and the second fluid through-hole (3b). In the present invention, the electric transmission body of the electric connection member is used for transmitting both current and cooling fluid, thus reducing the temperature rise of the electric connection member. In addition, the first or second connection end of the electric connection member can be detachably connected to the charging terminal of the charging seat or the connection terminal of the connector, making it very convenient to use.

## Description

### CROSS-REFERENCE TO RELATED APPLICATION

This application claims the benefit of Chinese Patent Application No. CN202310489188.X filed on May 4, 2023 in the State Intellectual Property Office of China, the whole disclosure of which is incorporated herein by reference.

### BACKGROUND OF THE INVENTION

### Field of the Invention

The present invention relates to an electric connection member and an electric connection assembly comprising the electric connection member, in particular to an electric connection member for detachable electrical connection with a charging seat.

### Description of the Related Art

In the prior art, in order to achieve electric connection between the charging gun and the battery pack, it is usually necessary to provide a charging seat, a cable, and a connector. The charging seat includes a charging seat housing and a charging terminal arranged in the charging seat housing. The connector includes a connector housing and a connection terminal arranged in the connector housing. One end of the cable is electrically connected to the charging terminal of the charging seat. The other end of the cable is electrically connected to the connection terminal of the connector. Therefore, in the prior art, it is necessary to provide separate charging terminal for the charging seat and separate connection terminal for the connector, which will result in higher costs. Moreover, in the prior art, it is necessary to crimp or weld the end of the cable to the charging terminal of the charging seat or the connection terminal of the connector, which will reduce manufacturing efficiency. In addition, in the prior art, there is a significant resistance in the connection between the cable and the charging terminal, or between the cable or the connection terminal, which can cause a significant temperature rise in the product and seriously affect the safety of the charging equipment.

In addition, in the prior art, in order to improve charging speed, the cable needs to carry large current, which can lead to higher temperature rise. To reduce temperature rise, large cross-sectional cable is usually used, which can lead to increased cost and volume.

### SUMMARY OF THE INVENTION

The present invention has been made to overcome or alleviate at least one aspect of the above mentioned disadvantages.

According to an aspect of the present invention, there is provided an electric connection member. The electric connection member comprises: an electric transmission body which is in the shape of a hollow tube; a first connection end which is connected to one end of the electric transmission body; and a second connection end which is connected to the other end of the electric transmission body. The electric connection member is an integral piece, and the first connection end is adapted to be detachably electrically connected to a charging terminal of a charging seat or the second connection end is adapted to be detachably electrically connected to a connection terminal of a connector. The inner cavity of the electric transmission body is served as a cooling fluid flow channel, and a first fluid through-hole and a second fluid through-hole are respectively formed in the circumferential walls at both ends of the electric transmission body, to allow the cooling fluid to flow into the electric transmission body through one of the first fluid through-hole and the second fluid through-hole, and flow out of the electric transmission body through the other of the first fluid through-hole and the second fluid through-hole.

According to an exemplary embodiment of the present invention, the first connection end is adapted to be detachably electrically connected to the charging terminal of the charging seat; the second connection end is served as a connection terminal of a connector and is adapted to be detachably electrically connected to a busbar of a battery pack.

According to another exemplary embodiment of the present invention, the first connection end is served as a charging terminal of a charging seat, and the first connection end is adapted to mate with a mating terminal of a charging gun; the second connection end is adapted to be detachably electrically connected to the connection terminal of the connector.

According to another exemplary embodiment of the present invention, the first connection end is adapted to be detachably electrically connected to the charging terminal of the charging seat; the second connection end is adapted to be detachably electrically connected to the connection terminal of the connector.

According to another exemplary embodiment of the present invention, the electric connection member is made of a single tubular piece, one end of which is flattened and bent to form the first connection end, and the other end of the tubular piece is flattened to form the second connection end; the middle part of the tubular piece is served as the electric transmission body, and the two ends of the electric transmission body are respectively sealed by the first connection end and the second connection end which are flattened.

According to another exemplary embodiment of the present invention, a first connection hole is formed in the first connection end that allows a first threaded connection member to pass through, so that the first connection end can be connected to the charging terminal through the first threaded connection member; and/or a second connection hole is formed in the second connection end that allows a second threaded connection member to pass through, so that the second connection end can be connected to the busbar through the second threaded connection member.

According to another aspect of the present invention, there is provided an electric connection assembly. The electric connection assembly comprises: two electric connection members; an insulation first pipe connection member which is fitted on one ends of two electric transmission bodies for connecting the first fluid through-holes at one ends of the two electric transmission bodies and connecting the first fluid through-holes to a cooling fluid circuit; and an insulation second pipe connection member which is fitted on the other ends of two electric transmission bodies for connecting the second fluid through-holes at the other ends of the two electric transmission bodies and connect the second fluid through-holes to the cooling fluid circuit.

According to an exemplary embodiment of the present invention, the first pipe connection member comprises: two first tubular parts which are respectively fitted on one ends of the two electric transmission bodies; a first communication part which is connected between the two first tubular parts and has a first communication hole; and a first pipe joint which is connected to the first communication part and has a first connection hole. The first connection hole is connected to the first communication hole, and the first communication hole is connected to the first fluid through-holes of the two electric transmission bodies, the first pipe joint is used to connect to the cooling fluid circuit.

According to another exemplary embodiment of the present invention, the second pipe connection member comprises: two second tubular parts which are respectively fitted on the other ends of the two electric transmission bodies; a second communication part which is connected between the two second tubular parts and has a second communication hole; and a second pipe joint which is connected to the second communication part and has a second connection hole. The second connection hole is connected to the second communication hole, and the second communication hole is connected to the second fluid through-holes of the two electric transmission bodies, the second pipe joint is used to connect to the cooling fluid circuit.

According to another exemplary embodiment of the present invention, two first sealing rings are fitted on one end of the electric transmission body, and the two first sealing rings are respectively positioned on the inner sides of the two ends of the first tubular part and compressed between the first tubular part and the electric transmission body to achieve sealing between the two; and/or two second sealing rings are fitted on the other end of the electric transmission body, and the two second sealing rings are respectively positioned on the inner sides of the two ends of the second tubular part and compressed between the second tubular part and the electric transmission body to achieve sealing between the two.

According to another exemplary embodiment of the present invention, a first mounting portion is formed on the outer surface of the first tubular part, a first threaded hole is formed in the first mounting portion, and a first positioning hole corresponding to the first threaded hole is formed on one end of the electric transmission body; the electric connection assembly further comprises a first positioning screw, which is threaded into the first threaded hole and inserted into the first positioning hole to prevent axial movement and circumferential rotation of the first pipe connection member relative to the electric transmission body.

According to another exemplary embodiment of the present invention, a second mounting portion is formed on the outer surface of the second tubular part, a second threaded hole is formed in the second mounting portion, and a second positioning hole corresponding to the second threaded hole is formed on one end of the electric transmission body; the electric connection assembly further comprises a second positioning screw, which is threaded into the second threaded hole and inserted into the second positioning hole to prevent axial movement and circumferential rotation of the second pipe connection member relative to the electric transmission body.

According to another exemplary embodiment of the present invention, a first recess is formed on the first mounting portion for accommodating the head of the first positioning screw, a first sealing ring is provided in the first recess and compressed between the head of the first positioning screw and the bottom surface of the first recess to achieve sealing between the two; and/or a second recess is formed on the second mounting portion to accommodate the head of the second positioning screw, a second sealing ring is provided in the second recess and compressed between the head of the second positioning screw and the bottom surface of the second recess to achieve sealing between the two.

According to another exemplary embodiment of the present invention, the electric connection assembly further comprises a heat shrink tubing which is heat shrink on the outer side of the electric transmission body of the electric connection member to form an outer insulation layer of the electric transmission body, the two ends of the first tubular part and the two ends of the second tubular part are wrapped in the heat shrink tube.

According to another exemplary embodiment of the present invention, the electric connection assembly further comprises a charging seat comprising a charging seat housing and a charging terminal installed in the charging seat housing, the first connection end of the electric connection member is detachably connected to the charging terminal.

According to another exemplary embodiment of the present invention, the electric connection assembly further comprises a charging seat including a charging seat housing, the first connection end of the electric connection member is inserted into the charging seat housing and served as a charging terminal of the charging seat for mating with a mating terminal of a charging gun.

According to another exemplary embodiment of the present invention, the electric connection assembly further comprises a first threaded connection member which passes through the first connection end of the electric connection member and is threaded to the charging terminal to secure the first connection end to the charging terminal.

According to another exemplary embodiment of the present invention, the electric connection assembly further comprises a connector including a connector housing, the second connection end of the electric connection member is inserted into the connector housing and served as a connection terminal of the connector for electrically connecting with a busbar of a battery pack.

According to another exemplary embodiment of the present invention, the electric connection assembly further comprises a connector including a connector housing and a connection terminal inserted into the connector housing, the second connection end of the electric connection member is detachably connected to the connection terminal of the connector.

According to another exemplary embodiment of the present invention, the second pipe connection member is located inside the connector housing and is used to connect with a cooling fluid circuit located inside the battery pack; or the second pipe connection member is located outside the connector housing and is used to connect with a cooling fluid circuit located outside the battery pack.

According to another aspect of the present invention, there is provided an electric connection member. The electric connection member comprises: an electric transmission body which is in the shape of a hollow tube; a first connection end which is connected to one end of the electric transmission body; and a second connection end which is connected to the other end of the electric transmission body. The electric connection member is an integral piece, and the first connection end is adapted to be detachably electrically connected to a connection terminal of one connector or the second connection end is adapted to be detachably electrically connected to a connection terminal of another connector. The inner cavity of the electric transmission body is served as a cooling fluid flow channel, and a first fluid through-hole and a second fluid through-hole are respectively formed in the circumferential walls at both ends of the electric transmission body, to allow the cooling fluid to flow into the electric transmission body through one of the first fluid through-hole and the second fluid through-hole, and flow out of the electric transmission body through the other of the first fluid through-hole and the second fluid through-hole.

In the aforementioned exemplary embodiments of the present invention, the electric transmission body of the electric connection member is used for transmitting both current and cooling fluid, thereby reducing the temperature rise of the electric connection member. In addition, in the present invention, one of the first or second connection ends of the electric connection member can be detachably connected to the charging terminal of the charging seat or the connection terminal of the connector, which is very convenient to use.

### BRIEF DESCRIPTION OF THE DRAWINGS

The above and other features of the present invention will become more apparent by describing in detail exemplary embodiments thereof with reference to the accompanying drawings, in which:
Figure 1 shows an illustrative perspective view of an electric connection assembly according to an exemplary embodiment of the present invention;
Figure 2 shows a cross-sectional view of an electric connection assembly according to an exemplary embodiment of the present invention;
Figure 3 shows an illustrative perspective view of an electric connection assembly according to an exemplary embodiment of the present invention, where the charging seat housing and connector housing are not shown;
Figure 4 shows a vertical sectional view of an electric connection assembly according to an exemplary embodiment of the present invention, where the charging seat housing and connector housing are not shown;
Figure 5 shows a horizontal sectional view of an electric connection assembly according to an exemplary embodiment of the present invention, where the charging seat housing and connector housing are not shown;
Figure 6 shows an illustrative perspective view of the first pipe connection member and the second pipe connection member according to an exemplary embodiment of the present invention; and
Figure 7 shows a cross-sectional view of the first and second pipe connection members according to an exemplary embodiment of the present invention.

### DETAILED DESCRIPTION OF PREFERRED EMBODIMENTS OF THE IVENTION

Exemplary embodiments of the present disclosure will be described hereinafter in detail with reference to the attached drawings, wherein the like reference numerals refer to the like elements. The present disclosure may, however, be embodied in many different forms and should not be construed as being limited to the embodiment set forth herein; rather, these embodiments are provided so that the present disclosure will be thorough and complete, and will fully convey the concept of the disclosure to those skilled in the art.

In the following detailed description, for purposes of explanation, numerous specific details are set forth in order to provide a thorough understanding of the disclosed embodiments. It will be apparent, however, that one or more embodiments may be practiced without these specific details. In other instances, well-known structures and devices are schematically shown in order to simplify the drawing.

According to a general concept of the present invention, there is provided an electric connection member. The electric connection member comprises: an electric transmission body which is in the shape of a hollow tube; a first connection end which is connected to one end of the electric transmission body; and a second connection end which is connected to the other end of the electric transmission body. The electric connection member is an integral piece, and the first connection end is adapted to be detachably electrically connected to a charging terminal of a charging seat or the second connection end is adapted to be detachably electrically connected to a connection terminal of a connector. The inner cavity of the electric transmission body is served as a cooling fluid flow channel, and a first fluid through-hole and a second fluid through-hole are respectively formed in the circumferential walls at both ends of the electric transmission body, to allow the cooling fluid to flow into the electric transmission body through one of the first fluid through-hole and the second fluid through-hole, and flow out of the electric transmission body through the other of the first fluid through-hole and the second fluid through-hole.

According to another general concept of the present invention, there is provided an electric connection assembly. The electric connection assembly comprises: two electric connection members; an insulation first pipe connection member which is fitted on one ends of two electric transmission bodies for connecting the first fluid through-holes at one ends of the two electric transmission bodies and connecting the first fluid through-holes to a cooling fluid circuit; and an insulation second pipe connection member which is fitted on the other ends of two electric transmission bodies for connecting the second fluid through-holes at the other ends of the two electric transmission bodies and connect the second fluid through-holes to the cooling fluid circuit.

According to another general concept of the present invention, there is provided an electric connection member. The electric connection member comprises: an electric transmission body which is in the shape of a hollow tube; a first connection end which is connected to one end of the electric transmission body; and a second connection end which is connected to the other end of the electric transmission body. The electric connection member is an integral piece, and the first connection end is adapted to be detachably electrically connected to a connection terminal of one connector or the second connection end is adapted to be detachably electrically connected to a connection terminal of another connector. The inner cavity of the electric transmission body is served as a cooling fluid flow channel, and a first fluid through-hole and a second fluid through-hole are respectively formed in the circumferential walls at both ends of the electric transmission body, to allow the cooling fluid to flow into the electric transmission body through one of the first fluid through-hole and the second fluid through-hole, and flow out of the electric transmission body through the other of the first fluid through-hole and the second fluid through-hole.

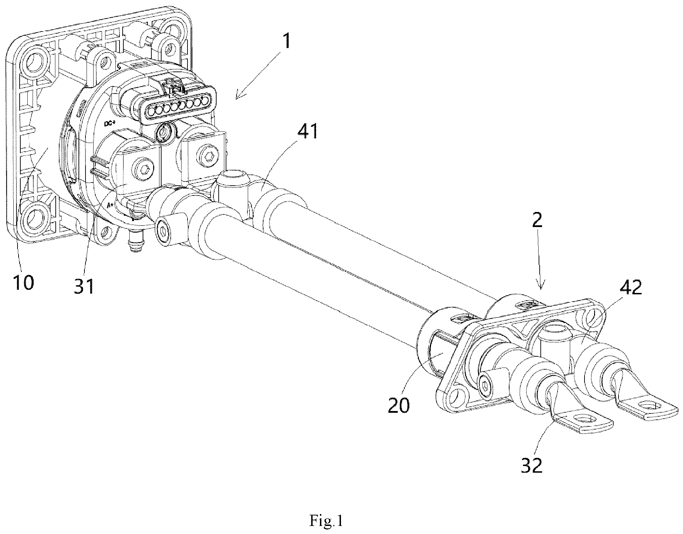

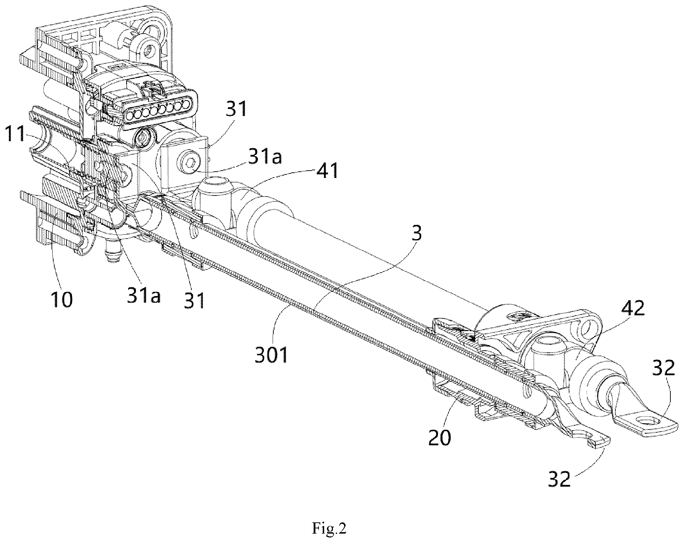

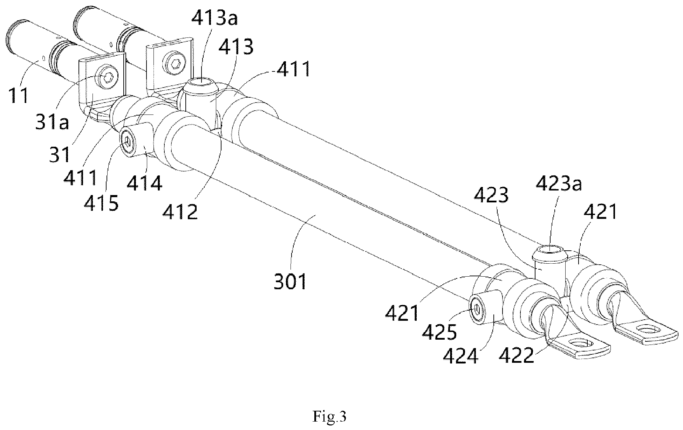

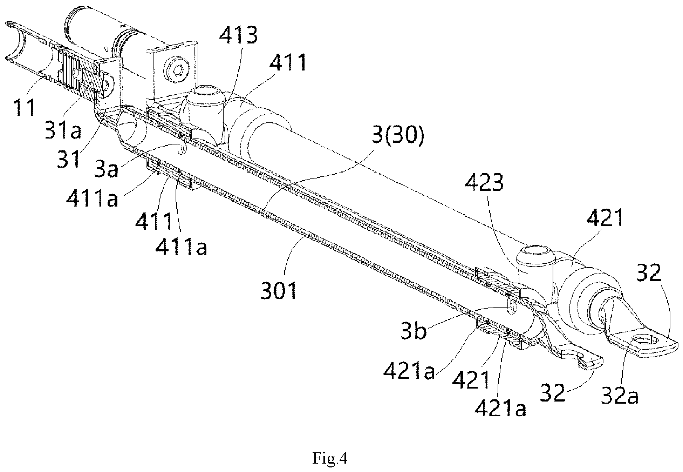

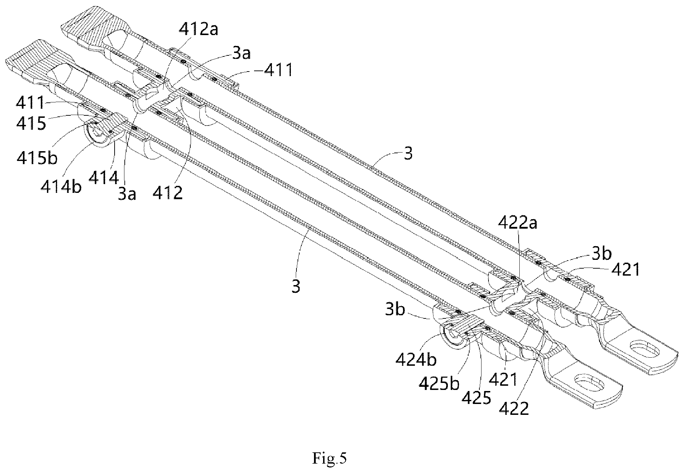

Figure 1 shows an illustrative perspective view of an electric connection assembly according to an exemplary embodiment of the present invention; Figure 2 shows a cross-sectional view of an electric connection assembly according to an exemplary embodiment of the present invention; Figure 3 shows an illustrative perspective view of an electric connection assembly according to an exemplary embodiment of the present invention, where the charging seat housing 10 and connector housing 20 are not shown; Figure 4 shows a vertical sectional view of an electric connection assembly according to an exemplary embodiment of the present invention, where the charging seat housing 10 and connector housing 20 are not shown; Figure 5 shows a horizontal sectional view of an electric connection assembly according to an exemplary embodiment of the present invention, where the charging seat housing 10 and connector housing 20 are not shown.

As shown in Figures 1 to 5, in an exemplary embodiment of the present invention, an electric connection member 3 is disclosed. The electric connection member 3 includes: an electric transmission body 30 and a first connection end 31. The electric transmission body 30 is in a hollow tube shape. The first connection end 31 is connected to one end of the electric transmission body 30. In the illustrated embodiment, the electric connection member 3 is an integral piece, and the first connection end 31 is suitable for detachable electric connection to the charging terminal 11 of the charging seat 1.

As shown in Figures 1 to 5, in the illustrated embodiments, the inner cavity of the electric transmission body 30 is served as a cooling fluid flow channel, and a first fluid through-hole 3a and a second fluid through-hole 3b are formed in the circumferential walls at both ends of the electric transmission body 30, respectively, to allow the cooling fluid to flow into the electric transmission body 30 through one of the first fluid through-hole 3a and the second fluid through-hole 3b, and flow out of the electric transmission body 30 through the other of the first fluid through-hole 3a and the second fluid through-hole 3b.

As shown in Figures 1 to 5, in the illustrated embodiments, the electric transmission body 30 of the electric connection member 3 is used for transmitting both current and cooling fluid, thus reducing the temperature rise of the electric connection member 3. In addition, in the present invention, the first connection end 31 of the electric connection member 3 can be detachably connected to the charging terminal 11 of the charging seat 1, which is very convenient to use.

As shown in Figures 1 to 5, in the illustrated embodiments, the electric connection member 3 further includes a second connection end 32. The second connection end 32 is connected to the other end of the electric transmission body 30 and served as a connecting terminal of a connector 2. In the illustrated embodiment, the second connection end 32 is adapted to be detachably electrically connected to a busbar (not shown) of a battery pack (not shown).

As shown in Figures 1 to 5, in the illustrated embodiments, the electric connection member 3 is made of a single tubular piece (not shown), one end of which is flattened and bent to form the first connection end 31, and the other end of the tubular piece is flattened to form the second connection end 32. The middle part of the tubular piece is served as the electric transmission body 30, and the two ends of the electric transmission body 30 are respectively sealed by the flattened first connection end 31 and the flattened second connection end 32.

As shown in Figures 1 to 5, in the illustrated embodiments, a first connection hole is formed in the first connection end 31 that allows a first threaded connection member 31a to pass through, so that the first connection end 31 can be connected to the charging terminal 11 through the first threaded connection member 31a. A second connection hole 32a is formed in the second connection end 32 to allow a second threaded connection member (not shown) to pass through, so that the second connection end 32 can be connected to the busbar through the second threaded connection member.

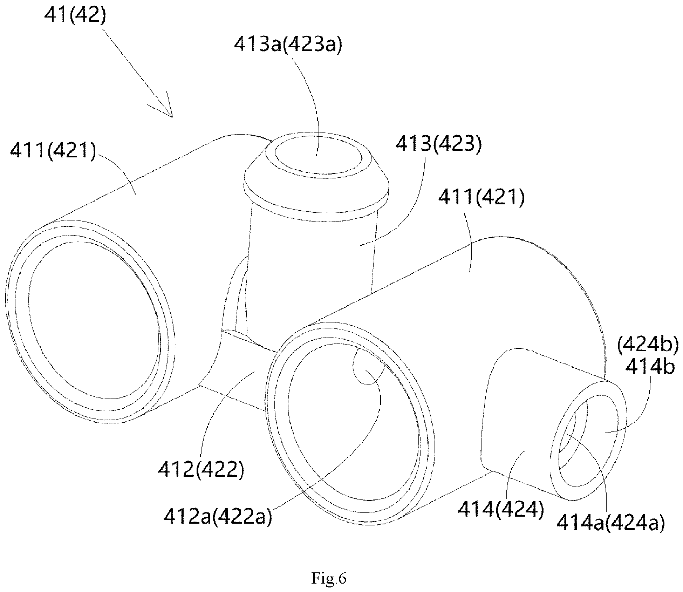

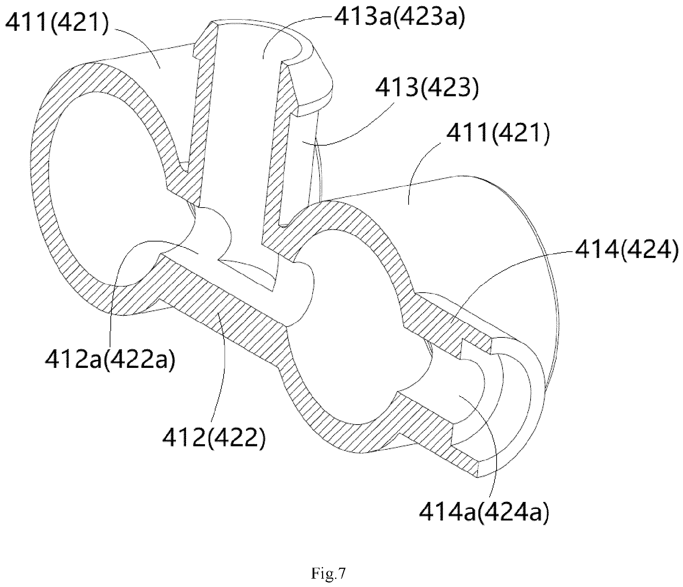

Figure 6 shows an illustrative perspective view of the first pipe connection member 41 and the second pipe connection member 42 according to an exemplary embodiment of the present invention; Figure 7 shows a cross-sectional view of the first pipe connection member 41 and the second pipe connection member 42 according to an exemplary embodiment of the present invention.

As shown in Figures 1 to 7, in another exemplary embodiment of the present invention, an electric connection assembly is also disclosed. The electric connection assembly includes two aforementioned electric connection members 3, an insulation first pipe connection member 41, and an insulation second pipe connection member 42. The insulation first pipe connection member 41 is fitted on one ends of two electric transmission bodies 30 to connect the first fluid through-holes 3a at one ends of the two electric transmission bodies 30 and connect the first fluid through-holes 3a to a cooling fluid circuit (not shown). The insulation second pipe connection member 42 is fitted on the other end of two electric transmission bodies 30 to connect the second fluid through-holes 3b at the other ends of two electric transmission bodies 30 and connect the second fluid through-holes 3b to the cooling fluid circuit.

As shown in Figures 1 to 7, in the illustrated embodiment, the first pipe connection member 41 comprises: two first tubular parts 411, a first communication part 412, and a first pipe joint 413. Two first tubular parts 411 are respectively fitted on one ends of two electric transmission bodies 30. The first communication part 412 is connected between two first tubular parts 411 and has a first communication hole 412a. The first pipe joint 413 is connected to the first communication part 412 and has a first connection hole 413a. The first connection hole 413a is connected to the first communication hole 412a, the first communication hole 412a is connected to the first fluid through-holes 3a of two electric transmission bodies 30, and the first pipe joint 413 is used to connect to the cooling fluid circuit.

As shown in Figures 1 to 7, in the illustrated embodiment, the second pipe connection member 42 comprises: two second tubular parts 421, a second communication part 422, and a second pipe joint 423. Two second tubular parts 421 are respectively fitted on the other ends of two electric transmission bodies 30. The second communication part 422 is connected between two second tubular parts 421 and has a second communication hole 422a. The second pipe joint 423 is connected to the second communication part 422 and has a second connection hole 423a. The second connection hole 423a is connected to the second communication hole 422a, the second communication hole 422a is connected to the second fluid through-holes 3b of two electric transmission bodies 30, and the second pipe joint 423 is used to connect to the cooling fluid circuit.

As shown in Figures 1 to 7, in an exemplary embodiment of the present invention, the first pipe connection member 41 and the second pipe connection member 42 can be completely identical and interchangeable, thereby reducing manufacturing costs and ease of use.

As shown in Figures 1 to 7, in the illustrated embodiment, two first sealing rings 411a are sleeved on one end of the electric transmission body 30. Two first sealing rings 411a are respectively positioned on the inner sides of both ends of the first tubular part 411 and compressed between the first tubular part 411 and the electric transmission body 30 to achieve sealing between the two.

As shown in Figures 1 to 7, in the illustrated embodiments, two second sealing rings 421a are sleeved on the other end of the electric transmission body 30. The two second sealing rings 421a are respectively positioned on the inner sides of the two ends of the second tubular part 421 and compressed between the second tubular part 421 and the electric transmission body 30 to achieve sealing between the two.

As shown in Figures 1 to 7, in the illustrated embodiments, a raised first mounting portion 414 is formed on the outer surface of the first tubular part 411, a first threaded hole 414a is formed in the first mounting portion 414, and a first positioning hole corresponding to the first threaded hole 414a is formed on one end of the electric transmission body 30. The electric connection assembly further includes a first positioning screw 415, which is threaded into the first threaded hole 414a and inserted into the first positioning hole to prevent axial movement and circumferential rotation of the first pipe connection member 41 relative to the electric transmission body 30.

As shown in Figures 1 to 7, in the illustrated embodiments, a raised second mounting portion 424 is formed on the outer surface of the second tubular part 421, a second threaded hole 424a is formed in the second mounting portion 424, and a second positioning hole corresponding to the second threaded hole 424a is formed on one end of the electric transmission body 30. The electric connection assembly also includes a second positioning screw 425, which is threaded into the second threaded hole 424a and inserted into the second positioning hole to prevent axial movement and circumferential rotation of the second pipe connection member 42 relative to the electric transmission body 30.

As shown in Figures 1 to 7, in the illustrated embodiments, a first recess 414b is formed on the first mounting portion 414 to accommodate the head of the first positioning screw 415, and a first sealing ring 415b is provided in the first recess 414b. The first sealing ring 415b is compressed between the head of the first positioning screw 415 and the bottom surface of the first recess 414b to achieve sealing between the two.

As shown in Figures 1 to 7, in the illustrated embodiments, a second recess 424b is formed on the second mounting portion 424 to accommodate the head of the second positioning screw 425, and a second sealing ring 425b is provided in the second recess 424b. The second sealing ring 425b is compressed between the head of the second positioning screw 425 and the bottom surface of the second recess 424b to achieve sealing between the two.

As shown in Figures 1 to 7, in the illustrated embodiments, the electric connection assembly further comprises a heat shrink tube 301, which is heat shrunk on the outer side of the electric transmission body 30 of the electric connection member 3 to form an external insulation layer of the electric transmission body 30. The two ends of the first tubular part 411 and the two ends of the second tubular part 421 are wrapped in the heat shrink tube 301.

As shown in Figures 1 to 7, in the illustrated embodiments, the electric connection assembly further comprises a charging seat 1, which comprises a charging seat housing 10 and a charging terminal 11 installed in the charging seat housing 10. The first connection end 31 of the electric connection member 3 is detachably connected to the charging terminal 11.

As shown in Figures 1 to 7, in the illustrated embodiments, the electric connection assembly further comprises a first threaded connection member 31a, which passes through the first connection end 31 of the electric connection member 3 and is threaded to the charging terminal 11 to secure the first connection end 31 to the charging terminal 11.

As shown in Figures 1 to 7, in the illustrated embodiments, the electric connection assembly further comprises a connector 2, which includes a connector housing 20. The second connection end 32 of the electric connection member 3 is inserted into the connector housing 20 to form a connection terminal of the connector 2 for electric connection with the busbar of the battery pack.

As shown in Figures 1 to 7, in the illustrated embodiments, the second pipe connection member 42 is located inside the connector housing 20 for connection with the cooling fluid circuit located inside the battery pack. However, the present invention is not limited to the illustrated embodiments, for example, the second pipe connection member 42 may be located outside the connector housing 20 for connection with a cooling fluid circuit located outside the battery pack.

As shown in Figures 1 to 7, in the illustrated embodiment, the first connection end 31 of the electric connection member 3 is detachably connected to the charging terminal 11 of the charging seat 1. The second connection end 32 of the electric connection member 3 is served as the connection terminal of connector 2 and is adapted to be detachably electrically connected to the busbar of the battery pack.

However, please note that the present invention is not limited to the illustrated embodiments. For example, in another exemplary embodiment of the present invention, the first connection end 31 of the electric connection member 3 can be inserted into the charging seat housing 10 to serve as the charging terminal of the charging seat 1. The second connection end 32 of the electric connection member 3 is adapted to be detachably electrically connected to the connection terminal of connector 2. At this time, the first connection end 31 of the electric connection member 3 is suitable for mating with the mating terminal of the charging gun.

However, please note that the present invention is not limited to the illustrated embodiments. For example, in another exemplary embodiment of the present invention, the first connection end 31 of the electric connection member 3 is suitable for detachable electric connection to the charging terminal 11 of the charging seat 1. The second connection end 32 of the electric connection member 3 is adapted to be detachably electrically connected to the connection terminal of connector 2.

In the embodiments shown in Figures 1 to 7, the electric connection member 3 is used for the electric connection between the charging seat and connector 2. However, the present invention is not limited to the illustrated embodiments, for example, in another exemplary embodiment of the present invention, an electric connection member is also disclosed. The electric connection member includes: an electric transmission body 30, a first connection end 31 and a second connection end 32. The electric transmission body 30 is in the shape of a hollow tube. The first connection end 31 is connected to one end of the electric transmission body 30. The second connection end 32 is connected to the other end of the electric transmission body 30. The electric connection member 3 is an integral piece, and the first connection end 31 is suitable for detachable electric connection to a connection terminal of one connector or the second connection end 32 is suitable for detachable electric connection to a connection terminal of another connector 2. The inner cavity of the electric transmission body 30 is served as a cooling fluid flow channel, and a first fluid through-hole 3a and a second fluid through-hole 3b are formed in the circumferential walls at both ends of the electric transmission body 30, respectively, to allow the cooling fluid to flow into the electric transmission body 30 through one of the first fluid through-hole 3a and the second fluid through-hole 3b, and flow out of the electric transmission body 30 through the other of the first fluid through-hole 3a and the second fluid through-hole 3b.

It should be appreciated for those skilled in this art that the above embodiments are intended to be illustrated, and not restrictive. For example, many modifications may be made to the above embodiments by those skilled in this art, and various features described in different embodiments may be freely combined with each other without conflicting in configuration or principle.

Although several exemplary embodiments have been shown and described, it would be appreciated by those skilled in the art that various changes or modifications may be made in these embodiments without departing from the principles and spirit of the disclosure, the scope of which is defined in the claims and their equivalents.

As used herein, an element recited in the singular and proceeded with the word "a" or "an" should be understood as not excluding plural of said elements or steps, unless such exclusion is explicitly stated. Furthermore, references to "one embodiment" of the present invention are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. An electric connection member, comprising:
an electric transmission body (30) which is in the shape of a hollow tube;
a first connection end (31) which is connected to one end of the electric transmission body (30); and
a second connection end (32) which is connected to the other end of the electric transmission body (30),
wherein the electric connection member (3) is an integral piece, and the first connection end (31) is adapted to be detachably electrically connected to a charging terminal (11) of a charging seat (1) or the second connection end (32) is adapted to be detachably electrically connected to a connection terminal of a connector (2),
wherein the inner cavity of the electric transmission body (30) is served as a cooling fluid flow channel, and a first fluid through-hole (3a) and a second fluid through-hole (3b) are respectively formed in the circumferential walls at both ends of the electric transmission body (30), to allow the cooling fluid to flow into the electric transmission body (30) through one of the first fluid through-hole (3a) and the second fluid through-hole (3b), and flow out of the electric transmission body (30) through the other of the first fluid through-hole (3a) and the second fluid through-hole (3b).

2. The electric connection member according to claim 1,
wherein the first connection end (31) is adapted to be detachably electrically connected to the charging terminal (11) of the charging seat (1); and
wherein the second connection end (32) is served as a connection terminal of a connector (2) and is adapted to be detachably electrically connected to a busbar of a battery pack.

3. The electric connection member according to claim 1,
wherein the first connection end (31) is served as a charging terminal of a charging seat (1), and the first connection end (31) is adapted to mate with a mating terminal of a charging gun; and
wherein the second connection end (32) is adapted to be detachably electrically connected to the connection terminal of the connector (2).

4. The electric connection member according to claim 1,
wherein the first connection end (31) is adapted to be detachably electrically connected to the charging terminal (11) of the charging seat (1); and
wherein the second connection end (32) is adapted to be detachably electrically connected to the connection terminal of the connector (2).

5. The electric connection member according to claim 2,
wherein the electric connection member (3) is made of a single tubular piece, one end of which is flattened and bent to form the first connection end (31), and the other end of the tubular piece is flattened to form the second connection end (32);
wherein the middle part of the tubular piece is served as the electric transmission body (30), and the two ends of the electric transmission body (30) are respectively sealed by the first connection end (31) and the second connection end (32) which are flattened.

6. The electric connection member according to claim 2,
wherein a first connection hole is formed in the first connection end (31) that allows a first threaded connection member (31a) to pass through, so that the first connection end (31) can be connected to the charging terminal (11) through the first threaded connection member (31a); and/or
wherein a second connection hole (32a) is formed in the second connection end (32) that allows a second threaded connection member to pass through, so that the second connection end (32) can be connected to the busbar through the second threaded connection member.

7. An electric connection assembly, comprising:
two electric connection members (3) as claimed in claim 1;
an insulation first pipe connection member (41) which is fitted on one ends of two electric transmission bodies (30) for connecting the first fluid through-holes (3a) at one ends of the two electric transmission bodies (30) and connecting the first fluid through-holes (3a) to a cooling fluid circuit; and
an insulation second pipe connection member (42) which is fitted on the other ends of two electric transmission bodies (30) for connecting the second fluid through-holes (3b) at the other ends of the two electric transmission bodies (30) and connect the second fluid through-holes (3b) to the cooling fluid circuit.

8. The electric connection assembly according to claim 7,
wherein the first pipe connection member (41) comprises:
two first tubular parts (411) which are respectively fitted on one ends of the two electric transmission bodies (30);
a first communication part (412) which is connected between the two first tubular parts (411) and has a first communication hole (412a); and
a first pipe joint (413) which is connected to the first communication part (412) and has a first connection hole (413a),
wherein the first connection hole (413a) is connected to the first communication hole (412a), and the first communication hole (412a) is connected to the first fluid through-holes (3a) of the two electric transmission bodies (30), the first pipe joint (413) is used to connect to the cooling fluid circuit.

9. The electric connection assembly according to claim 8,
wherein the second pipe connection member (42) comprises:
two second tubular parts (421) which are respectively fitted on the other ends of the two electric transmission bodies (30);
a second communication part (422) which is connected between the two second tubular parts (421) and has a second communication hole (422a); and
a second pipe joint (423) which is connected to the second communication part (422) and has a second connection hole (423a),
wherein the second connection hole (423a) is connected to the second communication hole (422a), and the second communication hole (422a) is connected to the second fluid through-holes (3b) of the two electric transmission bodies (30), the second pipe joint (423) is used to connect to the cooling fluid circuit.

10. The electric connection assembly according to claim 9, further comprising:
a heat shrink tubing (301) which is heat shrink on the outer side of the electric transmission body (30) of the electric connection member (3) to form an outer insulation layer of the electric transmission body (30),
wherein the two ends of the first tubular part (411) and the two ends of the second tubular part (421) are wrapped in the heat shrink tube (301).

11. The electric connection assembly according to any one of claims 7-10, further comprising:
a charging seat (1) comprising a charging seat housing (10) and a charging terminal (11) installed in the charging seat housing (10),
wherein the first connection end (31) of the electric connection member (3) is detachably connected to the charging terminal (11).

12. The electric connection assembly according to any one of claims 7-10, further comprising:
a charging seat (1) including a charging seat housing (10),
wherein the first connection end (31) of the electric connection member (3) is inserted into the charging seat housing (10) and served as a charging terminal (11) of the charging seat (1) for mating with a mating terminal of a charging gun.

13. The electric connection assembly according to claim 11, further comprising:
a connector (2) including a connector housing (20),
wherein the second connection end (32) of the electric connection member (3) is inserted into the connector housing (20) and served as a connection terminal of the connector (2) for electrically connecting with a busbar of a battery pack.

14. The electric connection assembly according to claim 12, further comprising:
a connector (2) including a connector housing (20) and a connection terminal inserted into the connector housing (20),
wherein the second connection end (32) of the electric connection member (3) is detachably connected to the connection terminal of the connector (2).

15. An electric connection member, comprising:
an electric transmission body (30) which is in the shape of a hollow tube;
a first connection end (31) which is connected to one end of the electric transmission body (30); and
a second connection end (32) which is connected to the other end of the electric transmission body (30),
wherein the electric connection member (3) is an integral piece, and the first connection end (31) is adapted to be detachably electrically connected to a connection terminal of one connector or the second connection end (32) is adapted to be detachably electrically connected to a connection terminal of another connector (2),
wherein the inner cavity of the electric transmission body (30) is served as a cooling fluid flow channel, and a first fluid through-hole (3a) and a second fluid through-hole (3b) are respectively formed in the circumferential walls at both ends of the electric transmission body (30), to allow the cooling fluid to flow into the electric transmission body (30) through one of the first fluid through-hole (3a) and the second fluid through-hole (3b), and flow out of the electric transmission body (30) through the other of the first fluid through-hole (3a) and the second fluid through-hole (3b).
